(19) **Europäisches Patentamt**
**European Patent Office**
**Office européen des brevets**

(11) **EP 2 025 059 B1**

(12) **EUROPEAN PATENT SPECIFICATION**

(45) Date of publication and mention
of the grant of the patent:
**06.05.2020 Bulletin 2020/19**

(21) Application number: **07761131.7**

(22) Date of filing: **23.04.2007**

(51) Int Cl.:
*H02M 3/158* (2006.01)       *H03K 19/00* (2006.01)
*H02M 1/00* (2006.01)

(86) International application number:
**PCT/US2007/067227**

(87) International publication number:
**WO 2007/133899 (22.11.2007 Gazette 2007/47)**

(54) **SYSTEM AND METHOD OF POWER DISTRIBUTION CONTROL OF AN INTEGRATED CIRCUIT**

SYSTEM UND VERFAHREN ZUR ENERGIEVERTEILUNGSSTEUERUNG EINER INTEGRIERTEN SCHALTUNG

SYSTÈME ET PROCÉDÉ DE COMMANDE DE DISTRIBUTION D'ÉNERGIE D'UN CIRCUIT INTÉGRÉ

(84) Designated Contracting States:
**AT BE BG CH CY CZ DE DK EE ES FI FR GB GR HU IE IS IT LI LT LU LV MC MT NL PL PT RO SE SI SK TR**

(30) Priority: **10.05.2006 US 431790**
**14.09.2006 US 532000**

(43) Date of publication of application:
**18.02.2009 Bulletin 2009/08**

(60) Divisional application:
**20166805.0**

(73) Proprietor: **Qualcomm Incorporated**
**San Diego, CA 92121-1714 (US)**

(72) Inventors:
• **CHUA-EOAN, Lew G.**
**Carlsbad, California 92009 (US)**
• **ANDREEV, Boris**
**San Diego, California 92121 (US)**
• **RIDDLE, Christopher C.**
**c/o Qualcomm Incorporated**
**San Diego, California 92121-1714 (US)**
• **SHI, Chunlei**
**Poway, California 92064 (US)**
• **JUNG, Seong-ook**
**San Diego, California 92121-1714 (US)**
• **TOMS, Thomas R.**
**Dripping Springs, Texas 78620 (US)**
• **GAGNE, Justin Joseph Rosen**
**San Diego, California 92126 (US)**

(74) Representative: **Heselberger, Johannes**
**Bardehle Pagenberg Partnerschaft mbB**
**Patentanwälte, Rechtsanwälte**
**Prinzregentenplatz 7**
**81675 München (DE)**

(56) References cited:
**EP-A1- 1 491 988          EP-A2- 1 411 616**
**WO-A-2005/038920      WO-A-2006/026627**
**US-A1- 2001 026 169    US-A1- 2003 025 130**
**US-A1- 2005 040 807    US-A1- 2006 015 312**
**US-B1- 6 242 896**

• **MUTOH S ET AL: "A 1 V multi-threshold voltage CMOS DSP with an efficient power management technique for mobile phone application" SOLID-STATE CIRCUITS CONFERENCE, 1996. DIGEST OF TECHNICAL PAPERS. 42ND ISSCC., 1996 IEEE INTERNATIONAL SAN FRANCISCO, CA, USA 8-10 FEB. 1996, NEW YORK, NY, USA,IEEE, US, 8 February 1996 (1996-02-08), pages 168-169,438, XP010156440 ISBN: 0-7803-3136-2**

## Description

### BACKGROUND

**Related Applications**

This application is related to Serial Number 11/431,790, entitled "System and Method of Silicon Switched Power Delivery Using a Package", filed on May 10, 2006.

**I.** *Field*

The present disclosure generally relates to systems and methods of power distribution control.

**II.** *Description of Related Art*

Advances in technology have resulted in smaller and more powerful personal computing devices. For example, a variety of portable personal computing devices, including wireless computing devices, such as portable wireless telephones, personal digital assistants (PDAs), and paging devices are small, lightweight, and easily carried by users. More specifically, portable wireless telephones, such as cellular (analog and digital) telephones and IP telephones, can communicate voice and data packets over wireless networks. Further, many such wireless telephones include other types of devices that are incorporated therein. For example, a wireless telephone can also include a digital still camera, a digital video camera, a digital recorder, and an audio file player. Also, such wireless telephones can include a web interface that can be used to access the Internet. As such, these wireless telephones include significant computing capabilities.

As the demand for new high performance features increases in portables systems, system level power management has become increasingly important in order to reduce power consumption and prolong battery life. Reducing power consumption of digital processes in portable electronic devices can improve the battery live and increase the available power budget for other features, such as color displays and backlighting, for example. To reduce power consumption, circuit designers have adopted various power management techniques.

A typical integrated circuit includes a substrate, which may include a plurality of embedded circuit structures, as well as one or more integrated circuit devices that are electrically coupled to the substrate. To reduce power consumption by such embedded circuit structures, one technique uses a plurality of power regulators to generate a plurality of power supplies, which may be utilized to satisfy power requirements of the various embedded circuit structures. Since at least one of the embedded circuit structures may use less power than others, a lower power supply may be provided to that structure, thereby conserving power in the overall power budget for other components. However, high voltage regulators consume a large amount of chip area.

Another technique to reduce power consumption involves switching power supplies to disable power to an embedded circuit structure when power is not needed. However, as semiconductor fabrication technologies achieve smaller and smaller devices, high voltage switches may be difficult to scale. Moreover, such switches contribute to layout and routing complexity.

WO 2005/038920 A2 discloses a semiconductor chip comprising a power management system to cooperate with an external source. The power management system is under control of the digital core and comprises a switching regulator and low drop out voltage regulators to supply a regulated 1.2V to a digital core and a regulated 1.8V to a digital I/O circuit.

Accordingly, it would be advantageous to provide an improved power distribution system and method that reduces power loss.

### SUMMARY

The aforementioned need is fulfilled by the subject-matter of the independent claims of the current invention. In a particular embodiment, a power manager integrated circuit according to claim 1 is disclosed that includes a first pin to supply power to a first power domain of an integrated circuit, a second pin to supply power to a second power domain of the integrated circuit, a switching regulator, and a logic comprising a head controller. The switching regulator is coupled to the first pin to provide a first regulated power supply to the first power domain and is coupled to the second pin to provide a second regulated power supply to the second power domain. The head controller is coupled to the first pin and to the second pin to uphold current flow to the first pin while selectively reducing current flow to the second pin during a low power event. The power manager integrated circuit further comprises a first transistor including a first terminal connected to the first pin, a control terminal coupled to the head controller, and a second terminal connected to the second pin; and a second transistor arranged in parallel with the first transistor including a first terminal connected to the first pin, a control terminal coupled to the control terminal of the first transistor, and a second terminal connected to the second pin; and wherein the head controller selectively deactivates the first transistor and the second transistor to shut off current flow to the second pin during the low power event.

In still another particular embodiment, a method according to claim 10 is provided that includes supplying a first regulated supply voltage to a first pin of a power manager integrated circuit and a second regulated supply voltage to a second pin of the power manager integrated circuit. The method further includes selectively upholding current flow to the second pin while selectively reducing current flow to the second pin in a low power event, wherein selectively reducing current flow comprises: deactivating a first transistor and a second transistor connected to the first pin and the second pin to substantially reduce current flow to the second pin during the low power event, wherein the first transistor includes a first terminal connected to the first pin, a control terminal coupled to a head controller of the power manager integrated circuit, and a second terminal connected to the second pin and wherein the second transistor is arranged in parallel with the first transistor and includes a first terminal connected to the first pin, a control terminal coupled to the control terminal of the first transistor, and a second terminal connected to the second pin.

One particular advantage provided by embodiments of the power manager integrated circuit is that semiconductor manufacturing processes may be utilized in conjunction with a viable, high voltage transistor device to limit current leakage. In one particular embodiment, the power manager integrated circuit may be fabricated using an older, lower cost semiconductor manufacturing technology and may be utilized to supply power to a circuit device produced with newer and/or more expensive semiconductor manufacturing technologies.

Another particular advantage is provided by embodiments of the power manager integrated circuit in that the power manager integrated circuit substantially reduces a leakage current of an electronic device to a current level of less than approximately 100 nanoamperes, when a head switch is disabled.

Yet another particular advantage is that a single regulator may be utilized within a power manager integrated circuit to provide a regulated power supply to a plurality of power domains of an integrated circuit device. One particular advantage of the single regulator is that costs of the power manager integrated circuit are reduced. Moreover, the single regulator of the power manager integrated circuit allows the state of the electronic device to be retained via a single power domain.

Still another advantage of a particular embodiment of a power manager integrated circuit coupled to an integrated circuit device is that leakage gating resources are not needed in the integrated circuit device to prevent current leakage. By eliminating the need for such gating resources, it may be possible to reduce the area and complexity of power routing of the integrated circuit device during an integrated circuit design process.

Other aspects, advantages, and features of the present disclosure will become apparent after review of the entire application, including the following sections: Brief Description of the Drawings, Detailed Description, and the Claims.

## BRIEF DESCRIPTION OF THE DRAWINGS

The aspects and the attendant advantages of the embodiments described herein will become more readily apparent by reference to the following detailed description when taken in conjunction with the accompanying drawings wherein:

FIG. 1A is a diagram of an illustrative example of an electronic device including a particular example of a power manager integrated circuit in a head switch configuration;

FIG. 1B is a diagram of an alternative example of an electronic device including a particular example of a power manager integrated circuit in a foot switch configuration;

FIG. 2 is a diagram of an illustrative portion of a particular example of a power manager integrated circuit;

FIG. 3 is a diagram of an illustrative portion of a particular embodiment of a power manager integrated circuit;

FIG. 4 is a diagram of an illustrative portion of another particular illustrative example of a power manager integrated circuit;

FIG. 5 is a block diagram of a particular illustrative embodiment of an integrated circuit device having a plurality of power domains and including a power manager integrated circuit according to FIG. 3;

FIG. 6 is a flow diagram of a particular illustrative embodiment of a method of selectively disabling current flow to at least one pin of a power manager integrated circuit;

FIG. 7 is a general diagram of an exemplary cellular telephone incorporating a processor and a memory in which the system and method of FIGS. 1-6 may be used;

FIG. 8 is a general diagram of an exemplary wireless Internet Protocol telephone incorporating a processor and a memory in which the system and method of FIGS. 1-6 may be used;

FIG. 9 is a general diagram of an exemplary portable digital assistant incorporating a processor and a memory in which the system and method of FIGS. 1-6 may be used; and

FIG. 10 is a general diagram of an exemplary audio file player incorporating a processor and a memory in which the system and method of FIGS. 1-6 may be used.

**DETAILED DESCRIPTION**

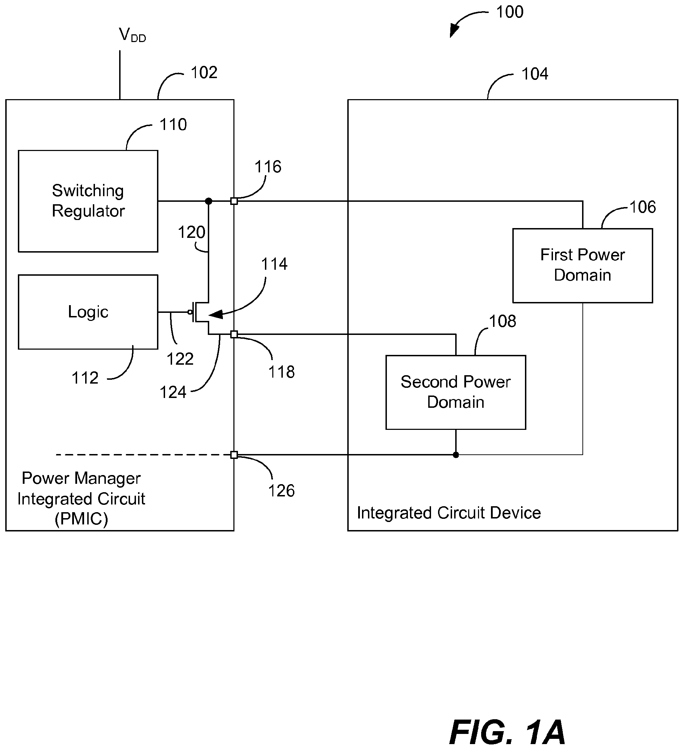

FIG. 1A is a block diagram of an illustrative example of an electronic device 100 including a particular example of a power manager integrated circuit (PMIC) 102 and an integrated circuit device 104. The integrated circuit device 104 may include multiple power domains, such as a first power domain 106 and a second power domain 108. The power manager integrated circuit 102 may include a switching regulator 110, logic 112, a transistor (switch) 114, a first pin 116 and a second pin 118. The switching regulator 110 is coupled to the first pin 116 and is coupled to the second pin 118 via the switch 114. The switch 114 may be a metal oxide semiconductor field effect transistor (MOSFET), a field effect transistor (FET), a bipolar junction transistor, or another circuit device that may be controlled by logic 112 to selectively enable and disable current flow to the second pin 118. In general, the switch 114 may be an n-channel MOSFET or a p-channel MOSFET device in the PMIC technology. If the switch 114 is an n-channel MOSFET device, then the switching regulator 110 may be at a larger voltage potential than the integrated circuit device 104.

The switch 114 includes a first terminal 120 coupled to the first pin 116, a control terminal 122 coupled to the logic 112, and a second terminal 124 coupled to the second pin 118. The first pin 116 may be coupled to the first power domain 106 of the integrated circuit device 104, and the second pin 118 may be coupled to the second power domain 108 of the integrated circuit device 104. A third pin 126 may provide a ground connection to the PMIC 102 for the first power domain and the second power domain.

In a normal operating mode, the switching regulator 110 provides a regulated power supply to the first pin 116. The logic 112 may activate the switch 114 via the control terminal 122 to provide at least a portion of the regulated power supply to the second pin 118. During a shut off event or a low power event, or during other power saving modes of operation, the logic 112 may selectively deactivate the switch 114 to substantially reduce current flow to the second pin 118. By reducing current flow to the second pin 118, the logic 112 substantially reduces current flow to the second power domain 108 of the integrated circuit device 104. In a particular embodiment, the switching regulator 110 may continue to deliver power to the first pin 116 and to the first power domain 106 after current flow to the second pin 118 is reduced. Thus, the switching regulator 110 may be utilized to selectively provide power to the second power domain 108 of the integrated circuit device 104.

In general, it should be understood that random access memory (RAM), such as synchronous dynamic random access memory (SDRAM) and other memory components account for a significant amount of static power consumption. For example, a 256 Mbit SDRAM (such as that produced by Elpida Memory, Inc. of Japan) may consume as much as 275 microamperes at 1.8 volts during normal operations or approximately $1.844 \times 10^{-9}$ milliwatts per bit. An SDRAM that consumes 1.02pA per bit at 1.8 volts consumes approximately 1.84 picowatts per bit. By utilizing the PMIC 102 to selectively turn off power to the second power domain 108 of the integrated circuit device 104, which may include an SDRAM device, power consumption for the circuit device 100 may be reduced. By utilizing a single switching regulator, such as the switching regulator 110, to produce the regulated power supply, it is possible to deliver a consistent power supply to one power domain, such as the first power domain 106, allowing state information to be retained in a memory location within the first power domain 106, while significantly reducing power to other power domains of the integrated circuit device 104, such as the second power domain 108.

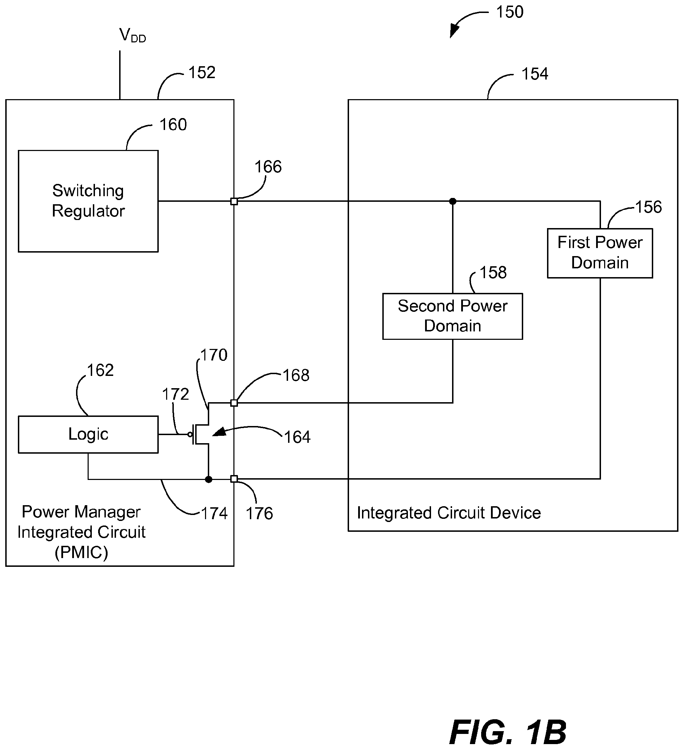

FIG. 1B is a block diagram of an alternative illustrative example of an electronic device 150 including a particular example of a power manager integrated circuit (PMIC) 152 and an integrated circuit device 154. The electronic device 150 includes a PMIC 152 arranged in foot-switch configuration. In particular, the integrated circuit device 154 may include multiple power domains, such as the first power domain 156 and the second power domain 158. The power manager integrated circuit 152 may include a switching regulator 160, logic 162, a transistor (switch) 164, a first pin 166, a second pin 168, and a third pin 176. The switching regulator 160 is coupled to the first power domain 156 and the second power domain 158 via the first pin 166. The switch 164 includes a first terminal 170 that is coupled to the second power domain 158 via the second pin 168. The switch 164 also includes a control terminal 172 that is coupled to the logic 162 and a second terminal 174 coupled to the logic 162 and to the third pin 176. The first power domain 156 may be coupled to the logic 162 via the third pin 176. In operation, the PMIC 152 may selectively disable the second power domain 158 by deactivating the switch 164 to reduce current flow, while providing power to the first power domain 156 via the switching regulator 160.

In general, it should be understood that while the PMIC 102 and the PMIC 152 of FIGS. 1A and 1B may include more than one switch 114 and that the integrated circuit device 104 may include a plurality of power domains. In a particular example, the switches may be selectively deactivated to disable power to selected power domains of a plurality of power domains of the integrated circuit device 104.

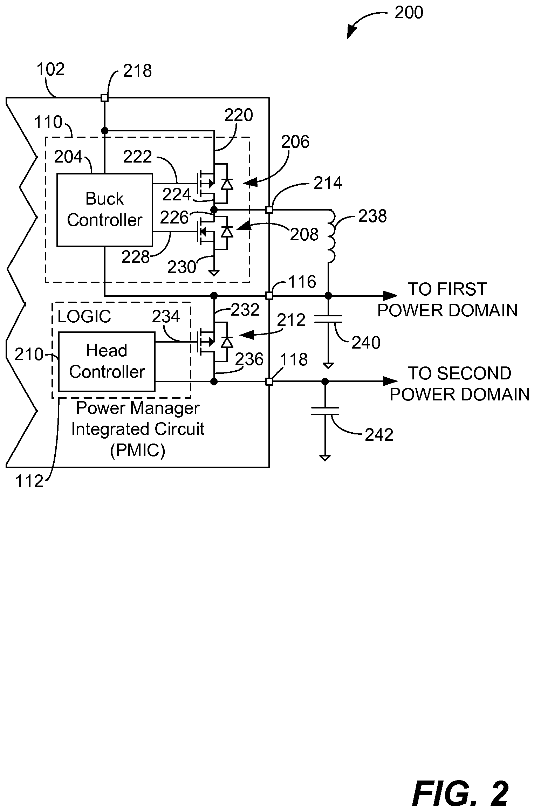

FIG. 2 is a diagram of an illustrative portion 200 of a particular example of a power manager integrated circuit (PMIC) 102. The PMIC 102 includes a switching regulator, such as the switching regulator 110 and logic 112. The switching regulator 110 may include a buck controller 204, a first transistor 206, and a second transistor 208. The logic 112 may include a head controller 210. The PMIC 102 may also include a third transistor 212, a first pin 116, a second pin 118, a third pin 214 and a fourth pin 218. The fourth pin 218 may be coupled to a power supply terminal, such as $V_{DD}$ in FIG. 1A.

In general, the first transistor 206 includes a first terminal 220 coupled to the fourth pin 218, a control terminal 222 coupled to the buck regulator 204, and a second terminal 224 coupled to the third pin 214. The second transistor 208 includes a first terminal 226 coupled to the third pin 214, a control terminal 228 coupled to the buck controller 204, and a second terminal 230 coupled to a voltage supply terminal, which may be an electrical ground. The third transistor 212 includes a first terminal 232 coupled to the first pin 116, a control terminal 234 coupled to the head controller 210, and a second terminal 236 coupled to the second pin 118.

An external inductor 238 may be coupled between the third pin 214 and the first pin 116. A capacitor 240 may be coupled between the first pin 116 and a voltage supply terminal, which may be an electrical ground, to filter the power supply to the first power domain. A capacitor 242 may be coupled between the second pin 118 and a voltage supply terminal, which may be an electrical ground, to filter the power supply to the second power domain.

In a particular example, the switching regulator 110 is coupled to the first pin 116 to provide a first regulated power supply to the first power domain and is coupled to the second pin 118 to provide a second regulated power supply to the second power domain via the third transistor 212. The head controller 210 is coupled to the control terminal 234 of the third transistor 212 and to the second pin 118 to selectively deactivate the third transistor 212, such as during a low power event. The third transistor 212 may be a high voltage transistor and may operate as a switch to selectively deactivate a second regulated power supply to the second power domain.

In operation, the head controller 210 may selectively activate the third transistor 212 to provide current flow to the second pin 118 during a normal operating mode. The head controller 210 may selectively deactivate the third transistor 212 to substantially reduce or shut off current flow to the second pin 118 during a low power event, such as a shut down event, an idle event, a reduced power event, or any combination thereof. In one particular embodiment, the head controller 210 may operate to substantially reduce leakage current via the third transistor 212, for example, to a current level less than approximately 100 nanoamperes.

In general, the third transistor 212 cooperates with the head controller 210 to use the regulated voltage supply provided by the buck regulator (e.g. the buck controller 204, the first transistor 206 and the second transistor 208) to provide a switched power supply to the second pin 118 without using extra components, such as extra voltage regulators. The first pin 116 receives a regulated output from the buck regulator 204, and the second pin 116 receives an unregulated output generated from the regulated output via the third transistor (head switch) 212. In a particular embodiment, the third transistor 212 can be designed to provide a voltage drop of approximately 5mV when a 100mA load is coupled to the second pin 118.

In general, a circuit design process typically includes establishing and maintaining correct circuit behavior under a variety of operating conditions, including variations in process, voltage, and temperature (PVT). Therefore, behavioral modeling of analog circuits typically includes extending the integrated circuit model to accurately represent the behavior of the integrated circuit at possible PVT values. To meet a 5mV DC loss specification, for example, the third transistor 212 should be designed to have an on-resistance that is small enough to maintain consistent performance at the PVT values. For example, the total loss resistance (R_loss) of the PMIC 102 may be written as a sum of the on-resistance (R on), the routing resistance (R_routing), and the package resistance (R_package) as follows:

$$R\_loss = R\_on + R\_routing + R\_package \qquad \text{(Equation 1)}$$

If a maximum R_loss is approximately 50 mohms and if R_package and R_routing are approximately 10 mohms and 20 mohms, respectively, the maximum on-resistance (R on) should be less than approximately 20 mohms across all PVT corners. In a particular embodiment, the on-resistance is less than approximately 7 mohms.

In a particular example, the output voltage specification specifies a medium voltage n-channel field effect transistor (NFET) for the third transistor 212. The on-resistance data of a medium voltage NFET in a Chartered 0.18nm high voltage complementary metal oxide semiconductor (CMOS) process may be estimated according to the following equation:

$$R\_on = 3.5 mohm * mm^2 \qquad \text{(Equation 2)}$$

If the on-resistance is approximately 7 mohms, the layout area of the third transistor may be estimated to be 0.5 mm².

In a particular embodiment, the estimated wafer price of approximately 2.4 cents per square millimeter indicates that the silicon cost is 1.2 cents for the third switch 212.

In one particular example, the PMIC 102 and an associated integrated circuit that includes multiple power domains (such as the integrated circuit device 104 of FIG. 1A) may be manufactured using different semiconductor manufacturing technologies. For example, the PMIC 102 may be fabricated using a 0.18nm high voltage CMOS process, while the integrated circuit device 104 may be manufactured using a 45nm process. In another particular embodiment, the PMIC 102 may be fabricated using a 45nm technology and the integrated circuit device may be fabricated using a 100nm technology (e.g. the PMIC 102 may be fabricated using an older fabrication technology, while the integrated circuit device, such as the integrated circuit device 104 of FIG. 1A, may be fabricated using a newer fabrication technology).

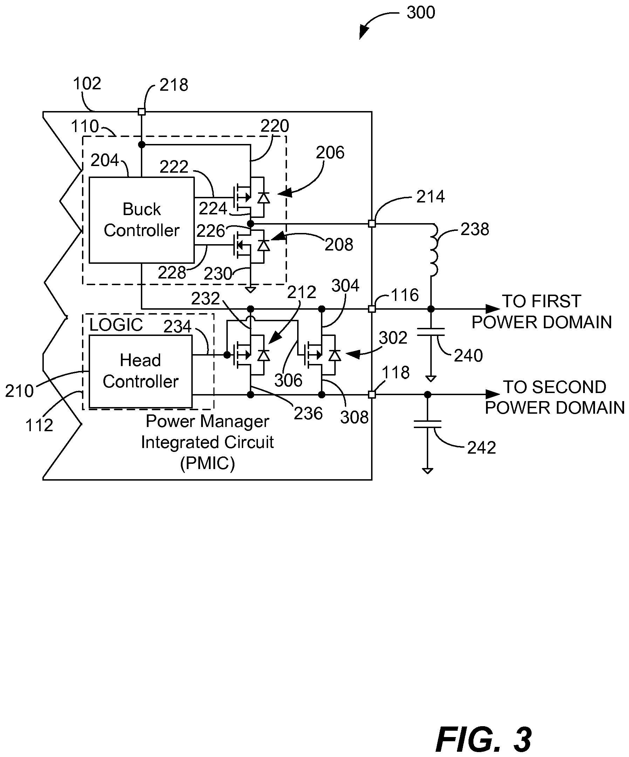

FIG. 3 is a diagram of a portion 300 of a particular illustrative embodiment of a power manager integrated circuit (PMIC) 102. The PMIC 102 may include the switching regulator 110, the logic 112, and other elements of the portion 200 of FIG. 2, as well as a fourth transistor 302 arranged in parallel with the third transistor 212. The fourth transistor 302 may include a first terminal 304 connected to the first pin 116, a control terminal 306 coupled to the control terminal 234 of the third transistor 212, and a second terminal 306 connected to the second pin 118.

In operation, the fourth transistor 302 may reduce a voltage drop across the third transistor 212 during normal operation, in part, by dividing current flow between the third transistor 212 and the fourth transistor 214. Moreover, by activating the third transistor 212 and the fourth transistor 302, more current may flow to the second pin 118 than would otherwise be possible without exceeding a current rating of the third transistor 212. During a low-power or shut down event, the head controller 210 may deactivate the third transistor 212 and the fourth transistor 302 to turn off current flow to the second pin 118, and to reduce leakage. In a particular embodiment, the leakage current may be reduced to a level that is less than approximately 100 nanoamperes.

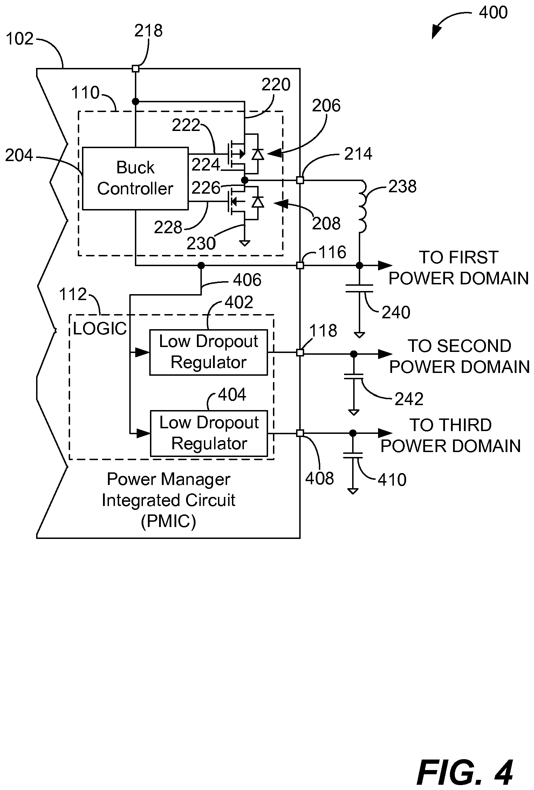

FIG. 4 is an illustrative diagram of a particular illustrative example of a portion 400 of another particular example of a power manager integrated circuit (PMIC) 102. The PMIC 102 includes the switching regulator 110 and the logic 112. In this particular illustrative example, the logic 112 includes a first low dropout regulator 402 and a second low dropout regulator 404. As used herein, a low dropout regulator may include a voltage regulator that provides a regulated voltage supply with a low voltage drop (e.g. low power consumption). The line 406 couples the low dropout regulators 402 and 404 to the first pin 116. The first low dropout regulator 402 is coupled to the second pin 118 to provide a second regulated power supply derived from the first regulated power supply provided to the first pin 116 by the switching regulator 110, and the second low dropout regulator 404 is coupled to a fifth pin 408. In this example, the first pin 116 may be coupled to a first power domain of a circuit device (such as the integrated circuit device 104 of FIG. 1A) to provide a first regulated power supply to the first power domain. The second pin 118 may be coupled to a second power domain of the circuit device to provide a second regulated power supply to the second power domain. The fifth pin 408 may be coupled to a third power domain of a circuit device to provide a third regulated power supply to the third power domain. The logic 112 may include multiple low dropout regulators and may be adapted to selectively control each of the low dropout regulators to activate and deactivate a regulated power supply to an associated power domain of the integrated circuit. A capacitor 410 may be coupled between the fifth pin 408 and a voltage supply terminal, which may be an electrical ground, to filter the power supply to the third power domain.

In this approach, the switching regulator 110 provides the first regulated power supply to the first pin 116 and the low dropout regulators 402 and 404 generate second and third regulated power supplies, respectively, based on the first regulated power supply. The low dropout regulators 402 and 404 can be designed to provide power supplies that are approximately matched supplies (such as within 5mV of each other). In a particular embodiment, the first low dropout (LDO) regulator 402 may be approximately a 300mA LDO regulator and the second LDO regulator 404 may be approximately a 150mA LDO regulator. The layout area of the first LDO regulator 402 and the second LDO regulator 404 may be estimated to be approximately $0.17mm^2$ and $0.11mm^2$, respectively. The total silicon cost of the two LDO regulators 402 and 404 may be approximately 0.67 cents.

In a particular example, the switching regulator 110 may be a high voltage power regulator. The LDO regulators 402 and 404 may be lower voltage regulators, which are adapted to derive power from the switching regulator 110. Thus, the LDO regulators 402 and 404 may be produced using less silicon area than the switching regulator 110.

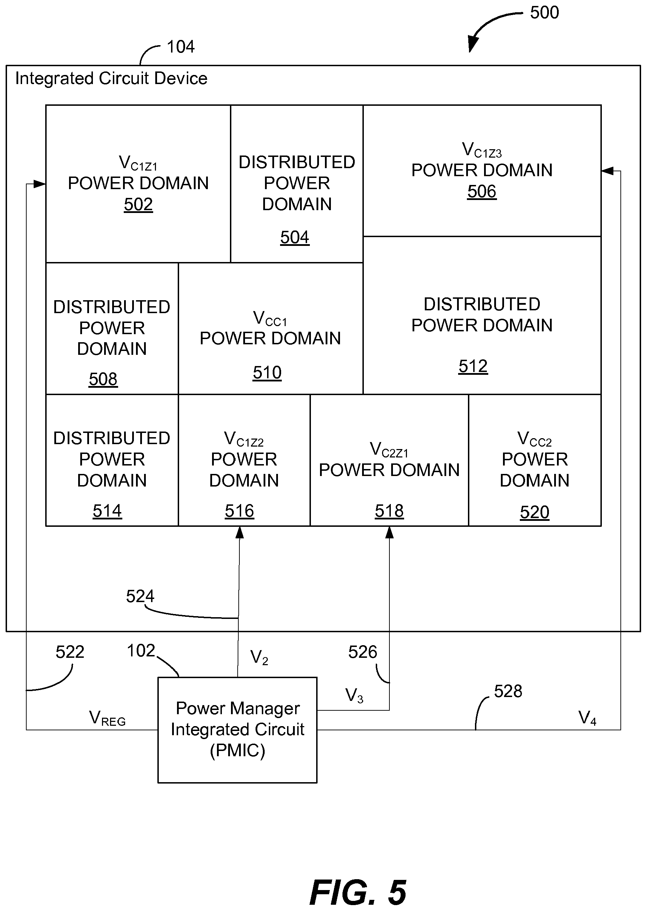

FIG. 5 is a block diagram of a system 500 including an integrated circuit device 104 having a plurality of power domains and including a power manager integrated circuit 102 according to FIGS. 1-4. The integrated circuit device 104 may include a plurality of power domains, including a $V_{C1Z1}$ power domain 502, a distributed power domain 504, a $V_{C1Z3}$ power domain 506, a distributed power domain 508, a $V_{CC1}$ power domain 510, distributed power domains 512 and 514, a $V_{C1Z2}$ power domain 516, a $V_{C2Z1}$ power domain 518, and a $V_{CC2}$ power domain 520. The power manager integrated circuit (PMIC) 102 may be adapted to provide one or more regulated power supplies to one or more of the power domains, using a single switching regulator, as shown in FIGS. 1-4. The PMIC 102 may provide a first regulated power supply $V_{REG}$, for example, to the $V_{C1Z1}$ power domain 502 via line 522. The PMIC 102 may also provide a second power supply ($V_2$) to the $V_{C1Z2}$ power domain 516 via line 524, a third power supply ($V_3$) to the $V_{C2Z1}$ power domain 518 via line 526, and a fourth power supply ($V_4$) to the $V_{C1Z3}$ power domain 506 via line 528. The second, third and

fourth power supplies ($V_2$, $V_3$, and $V_4$) may be unregulated if the PMIC 102 includes the particular arrangement of FIGS. 1-3 or may be regulated if the PMIC 102 includes the particular arrangement of FIG. 4.

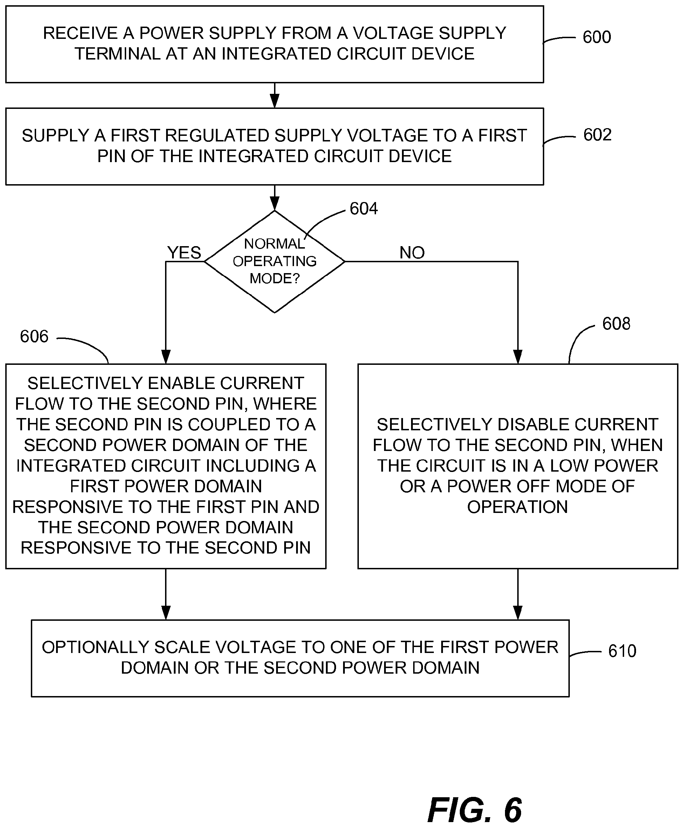

FIG. 6 is a flow diagram of a method of selectively disabling or substantially reducing current flow to at least one pin of a power manager integrated circuit of a system. A power supply may be received from a voltage supply terminal at a power manager integrated circuit (block 600). A first regulated supply voltage is supplied to a first pin of the power manager integrated circuit (block 602). When the system is in a normal operating mode (block 604), a current flow is selectively enabled to the second pin, where the second pin is coupled to a second power domain of the integrated circuit device including a first power domain responsive to the first pin and the second power domain responsive to the second pin (block 606). In general, the current flow may be selectively enabled by activating a transistor (such as the third transistor 212 of FIGS. 2 and 3) to enable current flow to the second pin. When the system in not in a normal operating mode, the current flow may be selectively disabled to the second pin, for example, when the system is in a low power or a power off mode of operation (block 608). The voltage level may optionally be scaled to one of the first power domain or the second power domain (block 610). In a particular embodiment, logic of the PMIC (such as logic 112 in FIG. 1A) may operate to scale a voltage level to one or more power domains of the integrated circuit device, to scale or adjust a power supply to a collapsible power domain, for example.

In a particular embodiment, the current flow may be selectively disabled by deactivating one or more transistors (e.g. the third transistor 212 and the fourth transistor 302 of FIG. 3) to substantially reduce current flow to the second pin (such as the second pin 118 of FIGS. 1-4). In a particular embodiment, the current flow to the second pin may be reduced to a current level that is less than approximately 100 nanoamperes, thereby reducing power to the second power domain.

In a particular embodiment, the method may include providing the regulated power supply to the first pin to provide power to the first power domain, which may include a memory, during the low power mode to retain a state of the integrated circuit device. In a particular embodiment, the first regulated power supply and the second regulated power supply may be at different power levels. For example, the power manager integrated circuit may provide a different regulated power supply to each domain of a plurality of power domains of the integrated circuit, and each of the power supplies may be selectively deactivated.

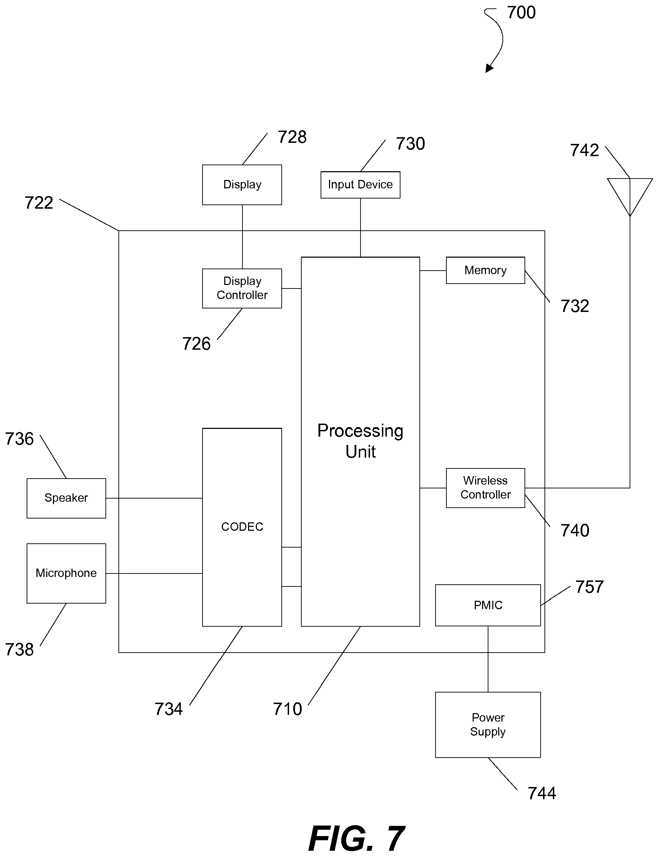

FIG. 7 illustrates an exemplary, non-limiting embodiment of a portable communication device that is generally designated 700. As illustrated in FIG. 7, the portable communication device includes an on-chip system 722 that includes a processing unit 710, which may be a general purpose processor, a digital signal processor, an advanced reduced instruction set machine processor, or any combination thereof. FIG. 7 also shows a display controller 726 that is coupled to the processing unit 710 and a display 728. Moreover, an input device 730 is coupled to the processing unit 710. As shown, a memory 732 is coupled to the processing unit 710. Additionally, a coder/decoder (CODEC) 734 can be coupled to the processing unit 710. A speaker 736 and a microphone 738 can be coupled to the CODEC 730. In a particular embodiment, the processing unit 710, the display controller 726, the memory 732, the CODEC 734, other components, or any combination thereof may receive power via one or more pins of a power manager integrated circuit (PMIC) 757, as shown in FIGS. 1-6 and described herein.

FIG. 7 also indicates that a wireless controller 740 can be coupled to the processing unit 710 and a wireless antenna 742. In a particular embodiment, a power supply 744 is coupled to the on-chip system 722. Moreover, in a particular embodiment, as illustrated in FIG. 7, the display 728, the input device 730, the speaker 736, the microphone 738, the wireless antenna 742, and the power supply 744 are external to the on-chip system 722. However, each is coupled to a component of the on-chip system 722. The PMIC 757 may be coupled to the power supply 744 to receive an unregulated power supply, which the PMIC 757 may utilize to generate the regulated power supply and to selectively activate power to one or more power domains of an integrated circuit device, which may include one or more elements (such as the processing unit 710, the wireless controller 740, the memory 732, the display controller 726 and the CODEC 734).

In a particular embodiment, the processing unit 710 may process instructions associated with programs necessary to perform the functionality and operations needed by the various components of the portable communication device 700. For example, when a wireless communication session is established via the wireless antenna a user can speak into the microphone 738. Electronic signals representing the user's voice can be sent to the CODEC 734 to be encoded. The processing unit 710 can perform data processing for the CODEC 734 to encode the electronic signals from the microphone. Further, incoming signals received via the wireless antenna 742 can be sent to the CODEC 734 by the wireless controller 740 to be decoded and sent to the speaker 736. The processing unit 710 can also perform the data processing for the CODEC 734 when decoding the signal received via the wireless antenna 742.

Further, before, during, or after the wireless communication session, the processing unit 710 can process inputs that are received from the input device 730. For example, during the wireless communication session, a user may be using the input device 730 and the display 728 to surf the Internet via a web browser that is embedded within the memory 732 of the portable communication device 700.

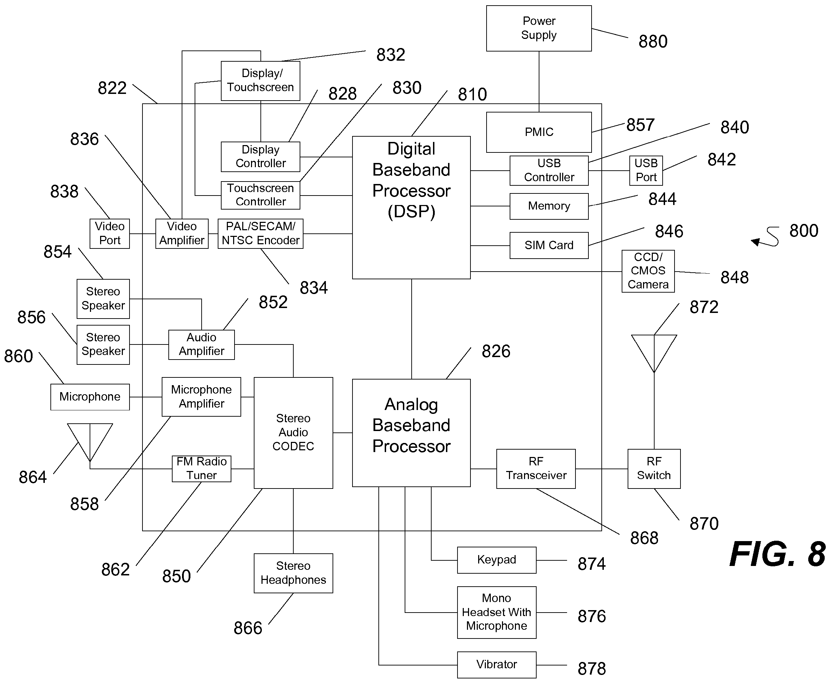

Referring to FIG. 8, an exemplary, non-limiting embodiment of a wireless telephone is shown and is generally designated 800. As shown, the wireless telephone 800 includes an on-chip system 822 that includes a digital baseband processor 810 and an analog baseband processor 826 that are coupled together. The wireless telephone 800 may alternatively include a general-purpose processor that is adapted to execute processor readable instructions to perform digital or analog signal processing, as well as other operations. In a particular embodiment, a general-purpose processor (not shown) may be included in addition to the digital baseband processor 810 and the analog baseband processor 826 to execute processor readable instructions. As illustrated in FIG. 8, a display controller 828 and a touchscreen controller 830 are coupled to the digital baseband processor 810. In turn, a touchscreen display 832 external to the on-chip system 822 is coupled to the display controller 828 and to the touchscreen controller 830. In a particular embodiment, the digital baseband processor 810, the analog baseband processor 826, the display controller 828, the touchscreen controller 830, other components, or any combination thereof may receive power from a power manager integrated circuit (PMIC) 857, such as the PMIC devices shown in FIGS. 1-6 and described herein.

FIG. 8 further indicates that a video encoder 834, e.g., a phase alternating line (PAL) encoder, a sequential couleur avec memoire (SECAM) encoder, or a national television system(s) committee (NTSC) encoder, is coupled to the digital baseband processor 810. Further, a video amplifier 836 is coupled to the video encoder 834 and to the touchscreen display 832. Also, a video port 838 is coupled to the video amplifier 836. As depicted in FIG. 8, a universal serial bus (USB) controller 840 is coupled to the digital baseband processor 810. Also, a USB port 842 is coupled to the USB controller 840. A memory 844 and a subscriber identity module (SIM) card 846 can also be coupled to the digital baseband processor 810. Further, as shown in FIG. 8, a digital camera 848 can be coupled to the digital baseband processor 810. In an exemplary embodiment, the digital camera 848 is a charge-coupled device (CCD) camera or a complementary metal-oxide semiconductor (CMOS) camera.

As further illustrated in FIG. 8, a stereo audio CODEC 850 can be coupled to the analog baseband processor 826. Moreover, an audio amplifier 852 can coupled to the to the stereo audio CODEC 880. In an exemplary embodiment, a first stereo speaker 854 and a second stereo speaker 856 are coupled to the audio amplifier 852. FIG. 8 shows that a microphone amplifier 858 can be also coupled to the stereo audio CODEC 850. Additionally, a microphone 860 can be coupled to the microphone amplifier 858. In a particular embodiment, a frequency modulation (FM) radio tuner 862 can be coupled to the stereo audio CODEC 850. Also, an FM antenna 864 is coupled to the FM radio tuner 862. Further, stereo headphones 866 can be coupled to the stereo audio CODEC 850.

FIG. 8 further indicates that a radio frequency (RF) transceiver 868 can be coupled to the analog baseband processor 826. An RF switch 870 can be coupled to the RF transceiver 868 and to an RF antenna 872. As shown in FIG. 8, a keypad 874 can be coupled to the analog baseband processor 826. Also, a mono headset with a microphone 876 can be coupled to the analog baseband processor 826. Further, a vibrator device 878 can be coupled to the analog baseband processor 826. FIG. 8 also shows that a power supply 880 can be coupled to the on-chip system 822. In a particular embodiment, the power supply 880 is a direct current (DC) power supply that provides power to the various components of the wireless telephone 800 that require power. Further, in a particular embodiment, the power supply is a rechargeable DC battery or a DC power supply that is derived from an alternating current (AC) to DC transformer that is connected to an AC power source. The PMIC 857 may be coupled to the power supply 880 to receive an unregulated power supply, which the PMIC 857 may utilize to generate a regulated power supply. The PMIC 857 may provide the regulated power supply to one or more power domains of an integrated circuit device, which may include one or more elements (such as the display controller 828, the digital signal processor 810, the USB controller 840, the touchscreen controller 830, the video amplifier 836, the PAL/SECAM/NTSC encoder 834, the memory 844, the SIM card 846, the audio amplifier 852, the microphone amplifier 858, the FM radio tuner 862, the stereo audio CODEC 850, the analog baseband processor 826, and the RF transceiver 868). A power domain of the integrated circuit device may include one or more of the elements. The power control unit 857 may selectively activate power to one or more of the power domains, as described above with respect to FIGS. 1-6.

In a particular embodiment, as depicted in FIG. 8, the touchscreen display 832, the video port 838, the USB port 842, the camera 848, the first stereo speaker 854, the second stereo speaker 856, the microphone 860, the FM antenna 864, the stereo headphones 866, the RF switch 870, the RF antenna 872, the keypad 874, the mono headset 876, the vibrator 878, and the power supply 880 are external to the on-chip system 822.

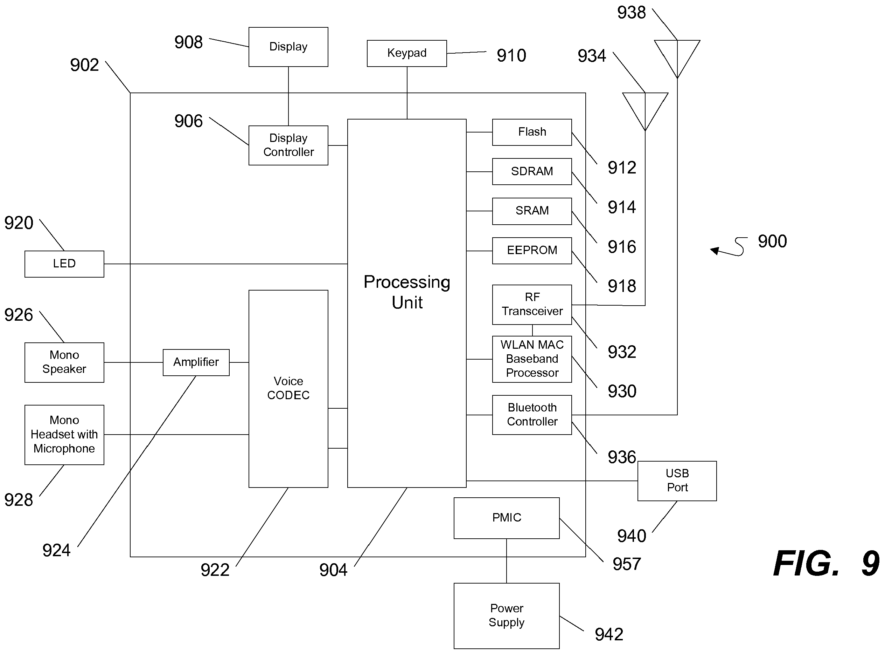

Referring to FIG. 9, an exemplary, non-limiting embodiment of a wireless Internet protocol (IP) telephone is shown and is generally designated 900. As shown, the wireless IP telephone 900 includes an on-chip system 902 that includes a processing unit 904. The processing unit 904 may be a digital signal processor, a general purpose processor, an advanced reduced instruction set computing machine processor, an analog signal processor, a processor to execute processor readable instruction sets, or any combination thereof. As illustrated in FIG. 9, a display controller 906 is coupled to the processing unit 904 and a display 908 is coupled to the display controller 906. In a particular embodiment, the display 908 is a liquid crystal display (LCD). A keypad 910 can be coupled to the processing unit 904. In a particular embodiment, the processing unit 904, the display controller 906, other components, or any combination thereof may receive power via a power manager integrated circuit (PMIC) 957, such as that shown in FIGS. 1-6 and described herein.

As further depicted in FIG. 9, a flash memory 912 can be coupled to the processing unit 904. A synchronous dynamic random access memory (SDRAM) 914, a static random access memory (SRAM) 916, and an electrically erasable programmable read only memory (EEPROM) 918 can also be coupled to the processing unit 904. FIG. 9 also shows that a light emitting diode (LED) 920 can be coupled to the processing unit 904. Additionally, in a particular embodiment, a voice CODEC 922 can be coupled to the processing unit 904. An amplifier 924 can be coupled to the voice CODEC 922 and a mono speaker 926 can be coupled to the amplifier 924. FIG. 9 further indicates that a mono headset 928 can also be coupled to the voice CODEC 922. In a particular embodiment, the mono headset 928 includes a microphone.

FIG. 9 also illustrates that a wireless local area network (WLAN) baseband processor 930 can be coupled to the processing unit 904. An RF transceiver 932 can be coupled to the WLAN baseband processor 930 and an RF antenna 934 can be coupled to the RF transceiver 932. In a particular embodiment, a Bluetooth controller 936 can also be coupled to the processing unit 904 and a Bluetooth antenna 938 can be coupled to the controller 936. A USB port 940 may be coupled to the processing unit 904. Moreover, a power supply 942 is coupled to the on-chip system 902 and provides power to the various components of the wireless IP telephone 900 via the PMIC 957.

In a particular embodiment, as indicated in FIG. 9, the display 908, the keypad 910, the LED 920, the mono speaker 926, the mono headset 928, the RF antenna 934, the Bluetooth antenna 938, the USB port 940, and the power supply 942 are external to the on-chip system 902. However, each of these components is coupled to one or more components of the on-chip system 902. The wireless VoIP device 900 includes the PMIC 957, which may be coupled to the power supply 942 to receive an unregulated power supply, which the PMIC 957 may utilize to generate the regulated power supply. If the on-chip system 902 includes a plurality of power domains, the PMIC 957 may selectively provide the regulated power supply to one or more of the plurality of power domains of the on-chip system. A power domain of the on-chip system 902 may include one or more elements, such as the display controller 906, the amplifier 924, the voice CODEC 922, the processing unit 904, the flash memory 912, the SDRAM 914, the SRAM 916, the EEPROM 918, the RF transceiver 932, WLAN MAC baseband processor 930, and the Bluetooth controller 936. The power control unit 957 may selectively activate power to one or more of the power domains, as described above with respect to FIGS. 1-6.

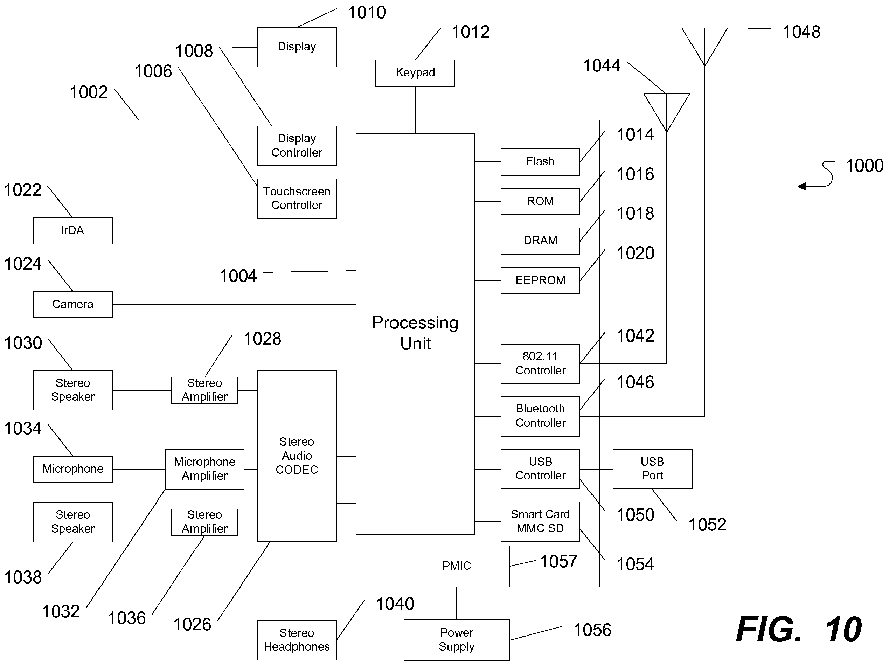

FIG. 10 illustrates an exemplary, non-limiting embodiment of a portable digital assistant (PDA) that is generally designated 1000. As shown, the PDA 1000 includes an on-chip system 1002 that includes a processing unit 1004. As depicted in FIG. 10, a touchscreen controller 1006 and a display controller 1008 are coupled to the processing unit 1004. Further, a touchscreen display 1010 is coupled to the touchscreen controller 1006 and to the display controller 1008. FIG. 10 also indicates that a keypad 1012 can be coupled to the processing unit 1004. In a particular embodiment, the processing unit 1004, the touchscreen controller 1006, the display controller 1008, other components, or any combination thereof may receive power via a power manager integrated circuit (PMIC) 1057, as shown in FIGS. 1-6 and described herein.

As further depicted in FIG. 10, a flash memory 1014 can be coupled to the processing unit 1004. The processing unit 1004 may be a digital signal processor (DSP), a general purpose processor, an advanced reduced instruction set computing machine, an analog signal processor, a processor adapted to execute processor readable instruction sets, or any combination thereof. Also, a read only memory (ROM) 1016, a dynamic random access memory (DRAM) 1018, and an electrically erasable programmable read only memory (EEPROM) 1020 can be coupled to the processing unit 1004. FIG. 10 also shows that an infrared data association (IrDA) port 1022 can be coupled to the processing unit 1004. Additionally, in a particular embodiment, a digital camera 1024 can be coupled to the processing unit 1004.

As shown in FIG. 10, in a particular embodiment, a stereo audio CODEC 1026 can be coupled to the processing unit 1004. A first stereo amplifier 1028 can be coupled to the stereo audio CODEC 1026 and a first stereo speaker 1030 can be coupled to the first stereo amplifier 1028. Additionally, a microphone amplifier 1032 can be coupled to the stereo audio CODEC 1026 and a microphone 1034 can be coupled to the microphone amplifier 1032. FIG. 10 further shows that a second stereo amplifier 1036 can be coupled to the stereo audio CODEC 1026 and to a second stereo speaker 1038. In a particular embodiment, stereo headphones 1040 can also be coupled to the stereo audio CODEC 1026.

FIG. 10 also illustrates that an 802.11 controller 1042 can be coupled to the processing unit 1004 and an 802.11 antenna 1044 can be coupled to the 802.11 controller 1042. Moreover, a Bluetooth controller 1046 can be coupled to the processing unit 1004 and a Bluetooth antenna 1048 can be coupled to the Bluetooth controller 1046. As depicted in FIG. 10, a USB controller 1050 can be coupled to the processing unit 1004 and a USB port 1052 can be coupled to the USB controller 1050. Additionally, a smart card 1054, e.g., a multimedia card (MMC) or a secure digital card (SD) can be coupled to the processing unit 1004. Further, as shown in FIG. 10, a power supply 1056 may be coupled to the PMIC 1057 of the on-chip system 1002 to provide power to the various components of the PDA 1000.

In a particular embodiment, as indicated in FIG. 10, the display 1010, the keypad 1012, the IrDA port 1022, the digital camera 1024, the first stereo speaker 1030, the microphone 1034, the second stereo speaker 1038, the stereo headphones 1040, the 802.11 antenna 1044, the Bluetooth antenna 1048, the USB port 1052, and the power supply 1056 are external to the on-chip system 1002. However, each of these components is coupled to one or more components on the on-chip system 1002. The PMIC 1057 may be coupled to the power supply 1056 to receive an unregulated power supply, which the PMIC 1057 may utilize to generate the regulated power supply. The PMIC 1057 may provide power to one or more power domains of the on-chip system 1002, which may include one or more elements (such as the display controller 1008, the touchscreen controller 1006, the stereo amplifier 1028, the microphone amplifier 1032, the stereo amplifier 1036, the processing unit 1004, the stereo audio CODEC 1026, the flash memory 1014, the ROM 1016, the DRAM 1018, the EEPROM 1020, the 802.11 controller 1042, the Bluetooth controller 1046, the USB controller 1050, and the smart card MMC SD 1054). A power domain of the on-chip system 1002 may include one or more of these elements, and the power control unit 1057 may selectively activate power to one or more of the power domains, as described above with respect to FIGS. 1-6.

The various illustrative logical blocks, configurations, modules, circuits, and algorithm steps described in connection with the embodiments disclosed herein may be implemented as electronic hardware, computer software, or combinations of both. To clearly illustrate this interchangeability of hardware and software, various illustrative components, blocks, configurations, modules, circuits, and steps have been described above generally in terms of their functionality. Whether such functionality is implemented as hardware or software depends upon the particular application and design constraints imposed on the overall system. Skilled artisans may implement the described functionality in varying ways for each particular application, but such implementation decisions should not be interpreted as causing a departure from the scope of the present disclosure.

The steps of a method or algorithm described in connection with the embodiments disclosed herein may be embodied directly in hardware, in a software module executed by a processor, or in a combination of the two. A software module may reside in RAM memory, flash memory, ROM memory, PROM memory, EPROM memory, EEPROM memory, registers, hard disk, a removable disk, a CD-ROM, or any other form of storage medium known in the art. An exemplary storage medium may be coupled to the processor such that the processor can read information from, and write information to, the storage medium. In the alternative, the storage medium may be integral to the processor. The processor and the storage medium may reside in an ASIC. The ASIC may reside in a computing device or a user terminal. In the alternative, the processor and the storage medium may reside as discrete components in a computing device or user terminal.

The previous description of the disclosed embodiments is provided to enable any person skilled in the art to make or use the present disclosure. Various modifications to such disclosed embodiments will be readily apparent to those skilled in the art, and the generic principles defined herein may be applied to other embodiments without departing from the scope of the disclosure. Thus, the present disclosure is not intended to be limited to the embodiments shown herein but is to be accorded the widest scope consistent with the principles and novel features as defined by the following claims.

**Claims**

1. A power manager integrated circuit (102) comprising:

   a first pin (116) to supply power to a first power domain (106) of an integrated circuit device (104);
   a second pin (118) to supply power to a second power domain (108) of the integrated circuit device (104);
   a switching regulator (110) coupled to the first pin (116) to provide a first regulated power supply to the first power domain (106) and coupled to the second pin (118) to provide a second regulated power supply to the second power domain (108);
   a logic (112) comprising a head controller (210) coupled to the first pin (116) and to the second pin (118) to uphold current flow to the first pin (116) while selectively reducing current flow to the second pin (118) during a low power event;
   a first transistor (212) including a first terminal (232) connected to the first pin (116), a control terminal (234) coupled to the head controller (210), and a second terminal (236) connected to the second pin (118);
   a second transistor (302) arranged in parallel with the first transistor (212) including a first terminal (304) connected to the first pin (116), a control terminal (306) coupled to the control terminal (234) of the first transistor (212), and a second terminal (306) connected to the second pin (118); and
   wherein the head controller (210) selectively deactivates the first transistor (212) and the second transistor (302) to shut off current flow to the second pin (118) during the low power event.

2. The power manager integrated circuit (102) of claim 1, wherein the low power event is selected from a group consisting of a shut down event, an idle event, and a reduced power event.

3. The power manager integrated circuit (102) of claim 1, wherein the head controller (210) limits the current flow to a current level less than approximately 100 nanoamperes during the low power event.

4. The power manager integrated circuit (102) of claim 1, wherein the switching regulator (110) comprises a buck controller (204) and a buck regulator responsive to the buck controller.

5. The power manager integrated circuit (102) of claim 1, wherein the switching regulator (110) comprises a buck controller (204) to produce a first regulated power supply and wherein the first pin (116) coupled to the first power domain (106) of the integrated circuit device (104) is responsive to the buck controller (204) to provide the first regulated power supply to the first power domain (106), and wherein the second pin (118) coupled to the second power domain (108) of the integrated circuit device (104) provides a second regulated power supply derived from the first regulated power supply to the second power domain (108).

6. The power manager integrated circuit (102) of claim 5, further comprising:

   a third pin (214) coupled to an external inductor (238);
   a third transistor (206) including a first terminal (220) coupled to a first voltage supply terminal, a control terminal (222) coupled to the buck controller (204), and a second terminal (224) coupled to the third pin (214);
   a fourth transistor (208) including a first terminal (226) coupled to the third pin (214), a control terminal (228) coupled to the buck controller (204), and
   a second terminal (230) coupled to a second voltage supply terminal;
   wherein the third transistor (206) and the fourth transistor (208) are responsive to the buck controller (204) to provide a power supply to the inductor via the third pin (214).

7. The power manager integrated circuit (102) of claim 5, wherein the buck controller (204) provides the first regulated power supply to the first domain (106) via the first pin (116) and selectively provides the second regulated power supply to the second domain (108) via the second pin (118).

8. The power manager integrated circuit (102) of claim 5, wherein the integrated circuit device (104) includes a plurality of power domains (106, 108) and wherein the buck controller (204) is adapted to provide the first regulated power supply to the first power domain (106) via the first pin (116) and the head controller (210) is adapted to provide the second regulated power supply to the second power domain (108) and at least one additional regulated power supply to one or more other power domains of the plurality of power domains.

9. The power manager integrated circuit (102) of claim 5, wherein the head controller (210) is adapted to scale at least one of a current level or a voltage level to the second pin (118) to control the second regulated power supply to the second power domain (108).

10. A method comprising:

   supplying a first regulated supply voltage to a first pin (116) of a power manager integrated circuit (102) and a second regulated supply voltage to a second pin (118) of the power manager integrated circuit (102); and
   during a low power event, uphold current flow to the first pin (116) while selectively reducing current flow to the second pin (118), wherein selectively reducing current flow comprises:

      deactivating a first transistor (212) and a second transistor (302) connected to the first pin (116) and to the second pin (118) to substantially reduce current flow to the second pin (118) during the low power event, wherein the first transistor (212) includes a first terminal (232) connected to the first pin (116), a control terminal (234) coupled to a head controller (210) of the power manager integrated circuit (102), and a second terminal (236) connected to the second pin (118) and wherein the second transistor (302) is arranged in parallel with the first transistor (212) and includes a first terminal (304) connected to the first pin (116), a control terminal (306) coupled to the control terminal (234) of the first transistor (212), and a second terminal (306) connected to the second pin (118).

11. The method of claim 10, further comprising:
   providing a supply voltage to the first pin (116) during the low power mode to retain a state of the integrated circuit device (104).

12. The method of claim 10, wherein the first regulated power supply is at a different power level than the second regulated power supply.

13. The method of claim 10, wherein selectively reducing current flow comprises reducing current flow to the second pin (118) to a current level that is less than approximately 100 nanoamperes.

14. The method of claim 10, further comprising:

scaling a voltage level to the second power domain (108) to adjust a power level of the second power domain (108) over a period of time.

15. A system comprising:

a power manager integrated circuit (102) according to any of claims 1 to 9; and
an integrated circuit device (104) including a first power domain (106) responsive to the first pin (116) and a second power domain (108) responsive to the second pin (118).

16. A mobile communications device (800, 900, 1000) comprising:

an integrated circuit device (104) including a plurality of power domains (106, 108); and
a power manager integrated circuit (102) according to any of claims 1 to 9.

17. The mobile communications device of claim 16, wherein the low power event comprises a power saving mode of operation.


**Patentansprüche**

1. Eine integrierte Schaltung zum Energiemanagement (102), aufweisend:

einen ersten Stift (116) zum Zuführen von Strom zu einer ersten Leistungsdomäne (106) einer integrierten Schaltungsvorrichtung (104);
einen zweiten Stift (118) zum Zuführen von Strom zu einer zweiten Leistungsdomäne (108) der integrierten Schaltungsvorrichtung (104);
einen Schaltregler (110), der mit dem ersten Stift (116) gekoppelt ist, um eine erste geregelte Stromzuführung für die erste Leistungsdomäne (106) bereitzustellen, und der mit dem zweiten Stift (118) gekoppelt ist, um eine zweite geregelte Stromzuführung für die zweite Leistungsdomäne (108) bereitzustellen;
eine Logik (112) mit einer Kopfsteuerung (210), die mit dem ersten Stift (116) und mit dem zweiten Stift (118) gekoppelt ist, um den Stromfluss zum ersten Stift (116) aufrechtzuerhalten, während der Stromfluss zum zweiten Stift (118) während eines Niedrigleistungsereignisses selektiv reduziert wird;
einen ersten Transistor (212) mit einem ersten Anschluss (232), der mit dem ersten Stift (116) verbunden ist, einem Steueranschluss (234), der mit der Kopfsteuerung (210) gekoppelt ist, und einem zweiten Anschluss (236), der mit dem zweiten Stift (118) verbunden ist;
einen zweiten Transistor (302), der parallel zu dem ersten Transistor (212) angeordnet ist und aufweist einen ersten Anschluss (304), der mit dem ersten Stift (116) verbunden ist, einen Steueranschluss (306), der mit dem Steueranschluss (234) des ersten Transistors (212) gekoppelt ist, und einen zweiten Anschluss (306), der mit dem zweiten Stift (118) verbunden ist; und
wobei die Kopfsteuerung (210) selektiv den ersten Transistor (212) und den zweiten Transistor (302) deaktiviert, um den Stromfluss zu dem zweiten Stift (118) während des Niedrigleistungsereignisses zu unterbinden.

2. Die integrierte Schaltung zum Energiemanagement (102) nach Anspruch **1**, wobei das Niedrigleistungsereignis aus einer Gruppe ausgewählt wird, die aus einem Abschaltungsereignis, einem Leerlaufereignis und einem Ereignis mit reduzierter Leistung besteht.

3. Die integrierte Schaltung zum Energiemanagement (102) nach Anspruch 1, wobei die Kopfsteuerung (210) den Stromfluss während des Niedrigleistungsereignisses auf ein Stromniveau von weniger als etwa 100 Nanoampere begrenzt.

4. Die integrierte Schaltung zum Energiemanagement (102) nach Anspruch 1, wobei der Schaltregler (110) eine Abwärtssteuerung (204) und einen auf die Abwärtssteuerung ansprechenden Abwärtsregulierer aufweist.

5. Die integrierte Schaltung zum Energiemanagement (102) nach Anspruch 1, wobei der Schaltregler (110) eine Abwärtssteuerung (204) aufweist, um eine erste geregelte Stromzuführung zu erzeugen, und wobei der erste Stift (116), der mit der ersten Leistungsdomäne (106) der integrierten Schaltungsvorrichtung (104) gekoppelt ist, auf die Abwärtssteuerung (204) anspricht, um die erste geregelte Stromzuführung für die erste Leistungsdomäne (106) bereitzustellen, und wobei der zweite Stift (118), der mit der zweiten Leistungsdomäne (108) der integrierten Schaltungsvorrichtung (104) gekoppelt ist, eine zweite geregelte Stromzuführung, die von der ersten geregelten Stromzuführung abgeleitet ist, für die zweite Leistungsdomäne (108) bereitstellt.

6. Die integrierte Schaltung zum Energiemanagement (102) nach Anspruch 5, weiter aufweisend:

einen dritten Stift (214), der mit einer externen Induktivität (238) gekoppelt ist;
einen dritten Transistor (206) mit einem ersten Anschluss (220), der mit einem ersten Spannungszuführungsanschluss gekoppelt ist, einem Steueranschluss (222), der mit der Abwärtssteuerung (204) gekoppelt ist, und einem zweiten Anschluss (224), der mit dem dritten Stift (214) gekoppelt ist;
einen vierten Transistor (208) mit einem ersten Anschluss (226), der mit dem dritten Stift (214) gekoppelt ist, einem Steueranschluss (228), der mit der Abwärtssteuerung (204) gekoppelt ist, und einem zweiten Anschluss (230), der mit einem zweiten Spannungszuführungsanschluss gekoppelt ist;
wobei der dritte Transistor (206) und der vierte Transistor (208) auf die Abwärtssteuerung (204) reagieren, um eine Stromzuführung für die Induktivität über den dritten Stift (214) bereitzustellen.

7. Die integrierte Schaltung zum Energiemanagement (102) nach Anspruch 5, wobei die Abwärtssteuerung (204) die erste geregelte Stromzuführung für die erste Domäne (106) über den ersten Stift (116) und selektiv die zweite geregelte Stromzuführung für die zweite Domäne (108) über den zweiten Stift (118) bereitstellt.

8. Die integrierte Schaltung zum Energiemanagement (102) nach Anspruch 5, wobei die integrierte Schaltungsvorrichtung (104) eine Vielzahl von Leistungsdomänen (106, 108) enthält und wobei die Abwärtssteuerung (204) so ausgelegt ist, dass sie die erste geregelte Leistungszuführung für die erste Leistungsdomäne (106) über den ersten Stift (116) bereitstellt und die Kopfsteuerung (210) so ausgelegt ist, dass sie die zweite geregelte Leistungszuführung für die zweite Leistungsdomäne (108) und mindestens eine zusätzliche geregelte Leistungszuführung für eine oder mehrere andere Leistungsdomänen der Vielzahl von Leistungsdomänen bereitstellt.

9. Die integrierte Schaltung zum Energiemanagement (102) nach Anspruch 5, wobei die Kopfsteuerung (210) so ausgelegt ist, dass sie mindestens einen Strompegel oder einen Spannungspegel auf den zweiten Stift (118) skaliert, um die zweite geregelte Leistungszuführung für die zweite Leistungsdomäne (108) zu steuern.

10. Ein Verfahren, aufweisend:

Zuführen einer ersten geregelten Zuführungsspannung zu einem ersten Stift (116) einer integrierten Schaltung zum Energiemanagement (102) und einer zweiten geregelten Zuführungsspannung zu einem zweiten Stift (118) der integrierten Schaltung zum Energiemanagement (102); und,
während eines Niedrigleistungsereignisses, Aufrechterhalten des Stromflusses zum ersten Stift (116), während der Stromfluss zum zweiten Stift (118) selektiv reduziert wird, wobei das selektive Reduzieren des Stromflusses aufweist:
Deaktivieren eines ersten Transistors (212) und eines zweiten Transistors (302), die mit dem ersten Stift (116) und dem zweiten Stift (118) verbunden sind, um den Stromfluss zum zweiten Stift (118) während des Niedrigleistungsereignisses wesentlich zu reduzieren, wobei der erste Transistor (212) einen ersten Anschluss (232), der mit dem ersten Stift (116) verbunden ist, und einen Steueranschluss (234), der mit einer Kopfsteuerung (210) der integrierten Schaltung zum Energiemanagement (102) gekoppelt ist, aufweist, und einen zweiten Anschluss (236), der mit dem zweiten Stift (118) verbunden ist, und wobei der zweite Transistor (302) parallel zu dem ersten Transistor (212) angeordnet ist und einen ersten Anschluss (304), der mit dem ersten Stift (116) verbunden ist, einen Steueranschluss (306), der mit dem Steueranschluss (234) des ersten Transistors (212) gekoppelt ist, und einen zweiten Anschluss (306), der mit dem zweiten Stift (118) verbunden ist, aufweist.

11. Das Verfahren nach Anspruch 10, weiter aufweisend:
Bereitstellen einer Zuführungsspannung an den ersten Stift (116) während des Niedrigleistungs-Modus, um einen Zustand der integrierten Schaltungsvorrichtung (104) beizubehalten.

12. Das Verfahren nach Anspruch 10, wobei sich die erste geregelte Stromzuführung auf einem anderen Leistungspegel als die zweite geregelte Stromzuführung befindet.

**13.** Das Verfahren nach Anspruch 10, wobei das selektive Reduzieren des Stromflusses das Reduzieren des Stromflusses zum zweiten Stift (118) auf einen Strompegel aufweist, der weniger als etwa 100 Nanoampere beträgt.

**14.** Das Verfahren nach Anspruch 10, weiter aufweisend:
Skalieren eines Spannungspegels auf die zweite Leistungsdomäne (108), um einen Leistungspegel der zweiten Leistungsdomäne (108) über eine Zeitspanne einzustellen.

**15.** Ein System, aufweisend:

eine integrierte Schaltung zum Energiemanagement (102) nach einem der Ansprüche 1 bis 9; und
eine integrierte Schaltungsvorrichtung (104) mit einer ersten Leistungsdomäne (106), die auf den ersten Stift (116) reagiert, und einer zweiten Leistungsdomäne (108), die auf den zweiten Stift (118) reagiert.

**16.** Ein mobiles Kommunikationsgerät (800, 900, 1000), aufweisend:

eine integrierte Schaltungsvorrichtung (104) mit einer Vielzahl von Leistungsdomänen (106, 108); und
eine integrierte Schaltung zum Energiemanagement (102) gemäß einem der Ansprüche 1 bis 9.

**17.** Das mobile Kommunikationsgerät nach Anspruch 16, wobei das Niedrigleistungsereignis einen stromsparenden Betriebsmodus aufweist.


**Revendications**

**1.** Un circuit intégré de gestion de puissance (102) comprenant :

une première broche (116) pour délivrer de la puissance à un premier domaine de puissance (106) d'un dispositif à circuits intégrés (104) ;
une deuxième broche (118) pour délivrer de la puissance un second domaine de puissance (108) du dispositif à circuits intégrés (104) ;
un régulateur à découpage (110) couplé à la première broche (116) pour délivrer une première alimentation de puissance régulée au premier domaine de puissance (106), et couplé à la deuxième broche (118) pour délivrer une seconde alimentation de puissance régulée au second domaine de puissance (108) ;
une logique (112) comprenant un contrôleur principal (210) couplé à la première broche (116) et à la deuxième broche (118) pour maintenir un passage de courant vers la première broche (116) tout en réduisant sélectivement un passage de courant vers la deuxième broche (118) durant un événement de faible puissance ;
un premier transistor (212) incluant une première borne (232) connectée à la première broche (116), une borne de contrôle (234) couplée au contrôleur principal (210) et une seconde borne (236) connectée à la deuxième broche (118) ;
un second transistor (302) agencé en parallèle au premier transistor (212), incluant une première borne (304) connectée à la première broche (116), une borne de contrôle (306) couplée à la borne de contrôle (234) du premier transistor (212) et une seconde borne (306) connectée à la deuxième broche (118) ; et
dans lequel le contrôleur principal (210) désactive de manière sélective le premier transistor (212) et le second transistor (302) pour interrompre le passage de courant vers la deuxième broche (118) durant l'événement de faible puissance.

**2.** Le circuit intégré de gestion de puissance (102) selon la revendication 1, dans lequel l'événement de faible puissance est sélectionné parmi un groupe constitué d'un événement d'arrêt, d'un événement d'inaction et d'un événement de puissance réduite.

**3.** Le circuit intégré de gestion de puissance (102) selon la revendication 1, dans lequel le contrôleur principal (210) limite le passage de courant à un niveau de courant inférieur à approximativement 100 nanoampères durant l'événement de faible puissance.

**4.** Le circuit intégré de gestion de puissance (102) selon la revendication 1, dans lequel le régulateur à découpage (110) comprend un contrôleur buck (204) et un régulateur buck répondant au contrôleur buck.

**5.** Le circuit intégré de gestion de puissance (102) selon la revendication 1,

dans lequel le régulateur à découpage (110) comprend un contrôleur buck (204) pour produire une première alimentation de puissance régulée et dans lequel la première broche (116) couplée au premier domaine de puissance (106) du dispositif à circuits intégrés (104) répond au contrôleur buck (204) pour délivrer la première alimentation de puissance régulée au premier domaine de puissance (106), et dans lequel la deuxième broche (118) couplée au second domaine de puissance (108) du dispositif à circuits intégrés (104) délivre une seconde alimentation de puissance régulée, dérivée de la première alimentation de puissance régulée, au second domaine de puissance (108).

**6.** Le circuit intégré de gestion de puissance (102) selon la revendication 5, comprenant en outre :

une troisième broche (214) couplée à une inductance externe (238) ;
un troisième transistor (206) incluant une première borne (220) couplée à une première borne de source de tension d'alimentation, une borne de contrôle (222) couplée au contrôleur buck (204), et une seconde borne (224) couplée à la troisième broche (214) ;
un quatrième transistor (208) incluant une première borne (226) couplée à la troisième broche (214), une borne de contrôle (228) couplée au contrôleur buck (204), et une seconde borne (230) couplée à une seconde borne de source de tension d'alimentation ;
dans lequel le troisième transistor (206) et le quatrième transistor (208) répondent au contrôleur buck (204) pour délivrer une alimentation de puissance à l'inductance via la troisième broche (214).

**7.** Le circuit intégré de gestion de puissance (102) selon la revendication 5, dans lequel le contrôleur buck (204) délivre la première alimentation de puissance régulée au premier domaine (106) via la première broche (116), et délivre de manière sélective la seconde alimentation de puissance régulée au second domaine (108) via la deuxième broche (118).

**8.** Le circuit intégré de gestion de puissance (102) selon la revendication 5, dans lequel le dispositif à circuits intégrés (104) inclut une pluralité de domaines de puissance (106, 108) et dans lequel le contrôleur buck (204) est apte à délivrer la première alimentation de puissance régulée au premier domaine de puissance (106) via la première broche (116) et le contrôleur principal (210) est apte à délivrer la seconde alimentation de puissance régulée au second domaine de puissance (108) et au moins une alimentation de puissance régulée supplémentaire à un ou plusieurs autres domaines de puissance de la pluralité de domaines de puissance.

**9.** Le circuit intégré de gestion de puissance (102) selon la revendication 5, dans lequel le contrôleur principal (210) est apte à normaliser au moins un niveau de courant ou un niveau de tension vers la deuxième broche (118) pour contrôler la seconde alimentation de puissance régulée vers le second domaine de puissance (108).

**10.** Un procédé comprenant :

la délivrance d'une première tension d'alimentation régulée à une première broche (116) d'un circuit intégré de gestion de puissance (102) et d'une seconde tension d'alimentation régulée à une deuxième broche (118) du circuit intégré de gestion de puissance (102) ; et
durant un événement de faible puissance, le maintien d'un passage de courant vers la première broche (116) tout en réduisant sélectivement le passage de courant vers la deuxième broche (118), dans lequel la réduction sélective du passage de courant comprend :
la désactivation d'un premier transistor (212) et d'un deuxième transistor (302) connecté à la première broche (116) et à la deuxième broche (118) pour réduire sensiblement un passage de courant vers la deuxième broche (118) durant l'événement de faible puissance, dans lequel le premier transistor (212) inclut une première borne (232) connectée à la première broche (116), une borne de contrôle (234) couplée à un contrôleur principal (210) du circuit intégré de gestion de puissance (102), et une seconde borne (236) connectée à la deuxième broche (118), et dans lequel le deuxième transistor (302) est agencé en parallèle au premier transistor (212) et inclut une première borne (304) connectée à la première broche (116), une borne de contrôle (306) couplée à la borne de contrôle (234) du premier transistor (212) et une seconde borne (306) connectée à la deuxième broche (118).

**11.** Le procédé selon la revendication 10, comprenant en outre :
la délivrance d'une tension d'alimentation à la première broche (116) durant le mode de faible puissance pour conserver un état du dispositif à circuits intégrés (104).

**12.** Le procédé selon la revendication 10, dans lequel la première alimentation de puissance régulée est à un niveau de puissance différent de celui de la seconde alimentation de puissance régulée.

**13.** Le procédé selon la revendication 10, dans lequel la réduction sélective d'un passage de courant comprend la réduction d'un passage de courant vers la deuxième broche (118) à un niveau de courant qui est inférieur à approximativement 100 nanoampères.

**14.** Le procédé selon la revendication 10, comprenant en outre :
la normalisation d'un niveau de tension vers le second domaine de puissance (108) pour ajuster un niveau de puissance du second domaine de puissance (108) au cours d'une période de temps.

**15.** Un système comprenant :

un circuit intégré de gestion de puissance (102) selon l'une des revendications 1 à 9 ; et
un dispositif à circuits intégrés (104) incluant un premier domaine de puissance (106) répondant à la première broche (116) et un second domaine de puissance (108) répondant à la deuxième broche (118).

**16.** Un dispositif de communication mobile (800, 900, 1000) comprenant :

un dispositif à circuits intégrés (104) incluant une pluralité de domaines de puissance (106, 108) ; et
un circuit intégré de gestion de puissance (102) selon l'une des revendications 1 à 9.

**17.** Le dispositif de communication mobile selon la revendication 16, dans lequel l'événement de faible puissance comprend un mode de fonctionnement en économie de puissance.

$V_{DD}$

Power Manager Integrated Circuit (PMIC)

102

110

Switching Regulator

Logic

112

120

122

124

116

114

118

126

100

104

First Power Domain

Second Power Domain

106

108

Integrated Circuit Device

*FIG. 1A*

*FIG. 1B*

FIG. 2

FIG. 3

FIG. 4

**FIG. 5**

RECEIVE A POWER SUPPLY FROM A VOLTAGE SUPPLY TERMINAL AT AN INTEGRATED CIRCUIT DEVICE — 600

SUPPLY A FIRST REGULATED SUPPLY VOTAGE TO A FIRST PIN OF THE INTEGRATED CIRCUIT DEVICE — 602

604 — NORMAL OPERATING MODE?

YES

NO

608

606

SELECTIVELY ENABLE CURRENT FLOW TO THE SECOND PIN, WHERE THE SECOND PIN IS COUPLED TO A SECOND POWER DOMAIN OF THE INTEGRATED CIRCUIT INCLUDING A FIRST POWER DOMAIN RESPONSIVE TO THE FIRST PIN AND THE SECOND POWER DOMAIN RESPONSIVE TO THE SECOND PIN

SELECTIVELY DISABLE CURRENT FLOW TO THE SECOND PIN, WHEN THE CIRCUIT IS IN A LOW POWER OR A POWER OFF MODE OF OPERATION

OPTIONALLY SCALE VOLTAGE TO ONE OF THE FIRST POWER DOMAIN OR THE SECOND POWER DOMAIN — 610

*FIG. 6*

700

728 Display

730 Input Device

742

722

Display Controller

726

Memory

732

736 Speaker

CODEC

Processing Unit

738 Microphone

Wireless Controller

740

PMIC

757

734

710

Power Supply

744

**FIG. 7**

FIG. 8

**FIG. 9**

908 — Display
910 — Keypad
902
906 — Display Controller
Processing Unit
Flash — 912
SDRAM — 914
SRAM — 916
EEPROM — 918
RF Transceiver — 932
WLAN MAC Baseband Processor — 930
Bluetooth Controller — 936
920 — LED
926 — Mono Speaker
924 — Amplifier
928 — Mono Headset with Microphone
922 — Voice CODEC
904
PMIC
957
940
USB Port
942 — Power Supply
900
938
934

EP 2 025 059 B1

FIG. 10

EP 2 025 059 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 11431790 A

- WO 2005038920 A2